# EUROPEAN PATENT APPLICATION

(11) **EP 2 816 592 A2**
(43) Date of publication of application: **24.12.2014**
(21) Application number: 13180329.8
(22) Date of filing: 14.08.2013
(51) Int. Cl.: H01L 23/373

(54) **Heat-dissipation sheet assembly manufactured by using electrochemical method**

(30) Priority: 18.06.2013 KR 20130069480
(71) Applicant: A-Tech Solution Co. Ltd., Gyeonggi-do 445-962 (KR)
(72) Inventor: Kim, Jong Seop, Gyeonggi-do 448-170 (KR); Lee, Ki Sung, Seoul 122-896 (KR)
(74) Representative: Meyer-Dulheuer, Karl-Hermann

(57) **Abstract**

There is provided a heat-dissipation sheet assembly comprising a heat-dissipation sheet layer having good heat conductivity and a protection layer(s) electrodeposited on one or both sides of the heat-dissipation sheet layer. When the heat-dissipation sheet layer is immersed in an aqueous solution for electrodeposition added with a material for electrodeposition and electric current is permitted to flow in the aqueous solution, the protection layer(s) is electrodeposited on the one or both sides of the heat-dissipation sheet layer. The heat-dissipation sheet assembly can be attached to a heat-generating unit by applying an adhesion layer to an underside of the heat-dissipation sheet assembly.

## Description

### CROSS-REFERENCE TO RELATED APPLICATION

This application claims the benefit of Korean Patent Application No. 10-2013-0069480, filed on June 18, 2013, the disclosure of which is hereby incorporated herein by reference in its entirety.

### BACKGROUND OF THE INVENTION

### 1. Field of the Invention

The present invention relates to a heat-dissipation sheet assembly and more particularly, to a heat-dissipation sheet assembly manufactured by using an electrochemical method.

### 2. Description of the Related Art

Recently, the structural complexity and preciseness have more and more increased in various electrical and electronic equipment including televisions, computers, medical devices, office equipment, communication equipment, etc. As the electrical and electronic components which are used in these devices and equipment have become smaller in size and the quantity thereof has increased, the heat generated in these components has increased. To efficiently release and disperse the heat generated, heat-dissipation sheets are widely used. Especially, as slim notebooks, tablet PCs, smart phones, plasma display panels (PDP), liquid crystal displays (LCD) and light-emitting diodes (LED) are now made smaller in size and lighter in weight, heat-dissipation sheets are widely used in the devices in which a lot of heat is generated.

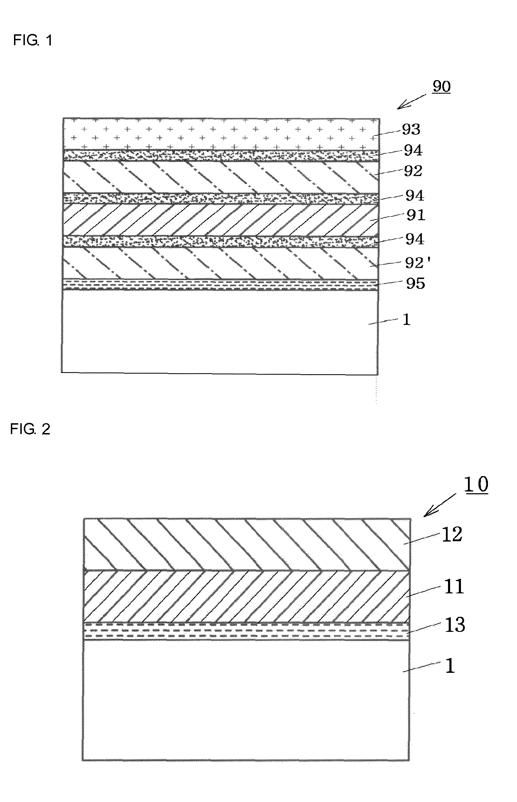

However, as shown in FIG. 1, a conventional heat-dissipation sheet assembly 90 includes a heat-dissipation sheet layer 91, such as graphite sheets having good heat conductivity, and heat-dissipation sheet protection layers 92, 92' made of plastic resin to protect the heat-dissipation sheet layer 91, which are bonded on and under the heat-dissipation sheet layer 91 by using an adhesive 94. Further, an outer protection layer 93 may be bonded on the upper heat-dissipation sheet protection layer 92 using the adhesive 94, to protect the upper heat-dissipation sheet protection layer 92 from an external impact or abrasion. An adhesion layer 95 is applied under the lower heat-dissipation sheet protection layer 92' to attach the heat-dissipation sheet assembly 90 to a heat-generating unit 1. In this conventional art, since the adhesive strength of the adhesive 94 decreases due to the repetitive heat generation from the heat-generating unit 1, the heat-dissipation sheet layer 91, the heat-dissipation sheet layer protection layers 92, 92' and the outer protection layer 93 may separate from one another. Furthermore, if the heat-dissipation sheet assembly 90 is inadvertently pulled or intentionally removed from the heat-generating unit 1 for repairing/checking a device or equipment, the heat-dissipation sheet layer 91 may be peeled off or damaged. In addition, since the adhesives 94 and the heat-dissipation sheet protection layers 92, 92' have a heat insulation effect preventing heat transfer, the effect of dissipating and dispersing the heat generated from the heat-generating unit 1 is hindered.

### SUMMARY OF THE INVENTION

Therefore, it is an object of the present invention to provide a heat-dissipation sheet assembly wherein a heat-dissipation sheet layer is prevented from being damaged even if an external force is applied to the heat-dissipation sheet assembly and no separation occurs between each layer even by the repetitive heat generation.

It is another object of the present invention to provide a heat-dissipation sheet assembly which is easily manufactured by a simple structure and has excellent effects of heat dissipation and dispersion.

In accordance with an aspect of the present invention, there is provided a heat-dissipation sheet assembly comprising: a heat-dissipation sheet layer having good heat conductivity, a protection layer which is electrodeposited on one or both sides of the heat-dissipation sheet layer. The protection layer is electrodeposited on one or both sides of the heat-dissipation sheet layer by immersing the heat-dissipation sheet layer into an aqueous solution for electrodeposition with an added material for electrodeposition and permitting electric current to flow in the aqueous solution for electrodeposition.

The heat-dissipation sheet assembly may be attached to a heat-generating unit by applying an adhesion layer to an underside of the heat-dissipation sheet assembly.

Preferably, the heat-dissipation sheet layer may be preprocessed by immersing the heat-dissipation sheet layer into an aqueous solution containing a copper component before immersing the heat-dissipation sheet layer into the aqueous solution for electrodeposition, for better electrodeposition.

Preferably, the heat-dissipation sheet layer may be a thin film made of a natural graphite, artificial graphite, copper, silver, aluminum or gold sheet. The material for electrodeposition may be gold, silver, copper, aluminium or nickel.

Preferably, the aqueous solution for electrodeposition may be a solution with added sodium cyanide or organic acid silver, or a solution with added nickel sulfamate, nickel chloride and boric acid.

Preferably, the thickness of the heat-dissipation sheet layer may be 10~40 µm and the thickness of the protection layer may be 0.1~3 µm.

Preferably, the heat-dissipation sheet assembly may further comprise an adhesion layer to attach the heat-dissipation sheet assembly to the heat-generating unit; and a release paper on an underside of the adhesion layer. The release paper can be easily detached from the adhesion layer.

### BRIEF DESCRIPTION OF THE DRAWINGS

The above and other features and advantages of the present invention will become more apparent to those of ordinary skill in the art by describing in detail the preferred embodiments thereof with reference to the attached drawings in which:
FIG. 1 is a schematic cross-sectional view of a conventional heat-dissipation sheet assembly;
FIG. 2 is a schematic cross-sectional view of a heat-dissipation sheet assembly according to one embodiment of the present invention; and
FIG. 3 is a schematic cross-sectional view of a heat-dissipation sheet assembly according to another embodiment of the present invention.

### [Description of numbers for constituents in drawings]

| | | | |
|---|---|---|---|
| 1: | heat-generating unit | | |
| 10, 10': | heat-dissipation sheet assembly | | |
| 11: | heat-dissipation sheet layer | 12,12': | protection layer |
| 13: | adhesion layer | 90: | heat-dissipation sheet assembly |
| 91: | heat-dissipation sheet layer | 92,92': | protection layer |
| 93: | outer protection layer | 94: | adhesive layer |
| 95: | adhesion layer | | |

### DETAILED DESCRIPTION OF THE PREFERRED EMBODIMENT

The present invention will now be described more fully hereinafter with reference to the accompanying drawings, in which the preferred embodiments of the invention are shown so that those of ordinary skill in the art can easily carry out the present invention.

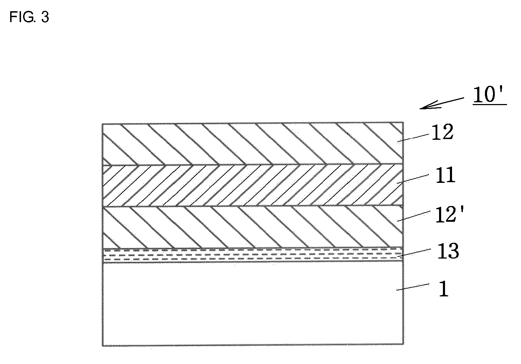

FIGS. 2 and 3 are schematic cross-sectional views of heat-dissipation sheet assemblies 10, 10' according to the present invention. FIG. 2 is a cross-sectional view of the heat-dissipation sheet assembly 10 according to one embodiment of the present invention, wherein a protection layer 12 is electrodeposited on only one side of a heat-dissipation sheet 11. FIG. 3 is a cross-sectional view of the heat-dissipation sheet assembly 10' according to another embodiment of the present invention, wherein protection layers 12, 12' are electrodeposited on and under a heat-dissipation sheet layer 11.

As shown in FIGS. 2 and 3, the heat-dissipation sheet assemblies 10, 10' comprise the heat-dissipation sheet layer 11 having good heat conductivity and the protection layers 12, 12' to protect the heat-dissipation sheet layer 11. The heat-dissipation sheet layer 11 is a thin film made of a natural graphite sheet or an artificial graphite sheet having high heat conductivity, or a metal sheet having good heat conductivity, such as copper, silver, aluminium or gold. The thickness of the heat-dissipation sheet layer 11 may be about 10-60 µm, preferably about 10-40 µm. The protection layers 12, 12' are made of metal materials such as gold, silver, copper, aluminium or nickel. The protection layers 12, 12' protect the heat-dissipation sheet layer 11 by preventing it from being damaged or worn away. In addition, the protection layers 12, 12' have good heat conductivity, allowing the heat generated from the heat-generating unit 1 to be effectively dissipated and dispersed through the heat-dissipation sheet layer 11. The protection layer 12 may be applied only on the heat-dissipation sheet layer 11 as shown in FIG. 2, or the protection layers 12, 12' may be applied on and under the heat-dissipation sheet layer 11 as shown in FIG. 3 to further increase the capability of protecting the heat-dissipation sheet layer 11. The protection layers are ultra thin films and the thickness of the each protection layer 12, 12' may be about 0.1~5 µm, preferably about 0.1~3 µm. Therefore, since the heat-dissipation sheet assemblies 10, 10' according to the present invention are thin plates about 10~70 µm in the whole thickness, these are readily and effectively used as heat-dissipating means for the light and thin electrical and electronic products.

An important point is that the protection layers 12, 12' are electrodeposited to the one or both sides of the heat-dissipation sheet layer 11 by using an electrochemical method, without using any adhesives. As a method to electrodeposit the protection layers 12, 12' to the heat-dissipation sheet layer 11, the material for electrodeposition, such as gold, silver, copper or aluminum, is added, in an adequate ratio, into an aqueous solution for electrodeposition, for example, an aqueous solution with added sodium cyanide or organic acid silver, and then the heat-dissipation sheet layer 11 is immersed in the aqueous solution for electrodeposition with the added material for electrodeposition. Thereafter, when the heat-dissipation sheet layer 11 is connected to a cathode and an anode plate is installed nearby one side or both sides of the heat-dissipation sheet layer 11, electric current is allowed to flow. Then, the material for electrodeposition dissolved in the aqueous solution for electrodeposition is electrodeposited to one side or both sides of the heat-dissipation sheet layer 11, to form the protection layers 12, 12'. If the material of the protection layer, that is, the material for electrodeposition is nickel, the aqueous solution for electrodeposition may be a solution with added nickel sulfamate, nickel chloride and boric acid. If the heat-dissipation sheet layer is preprocessed by being immersed into an aqueous solution containing a copper component before being immersed into the aqueous solution, the electrodeposition may be better enhanced.

As shown in FIGS. 2 and 3, the heat-dissipation sheet assemblies 10, 10' completed in the above-described manner may be attached to the heat-generating unit 1 by applying an adhesion layer 13 to the undersides of the heat-dissipation sheet assemblies 10, 10' or to the topside of the heat-generating unit 1. The adhesion layer 13 may be, for example, a silicon or epoxy-based adhesive.

As described above, when the protection layers 12, 12' are electrodeposited to the heat-dissipation sheet layer 11, the elements of the protection layers 12, 12' permeate into an inner structure of the heat-dissipation sheet layer 11 and the bonding force further increases. Therefore, even if heat is repetitively generated from the heat-generating unit 1, the bonding strength between the heat-dissipation sheet layer 11 and the protection layers 12, 12' does not fall. Accordingly, for example, if a force is applied to pull the heat-dissipation sheet assemblies 10, 10' from the heat-generating unit 1 for checking or repairing the heat-generating unit 1, the entire heat-dissipation sheet assemblies 10, 10' will be separated from the heat-generating unit 1 without the heat-dissipation sheet layer 11 itself being damaged or without the heat-dissipation sheet layer 11 and the protection layers 12, 12' being separated.

The heat-dissipation sheet assemblies 12, 12' according to the present invention may comprise an adhesion layer 13 to attach the heat-dissipation sheet assemblies 12, 12' to the heat-generating unit 1, and a release paper to protect this adhesion layer 13. The release paper may be attached to the adhesion layer 13, and can be easily detached from the adhesion layer 13. For the release paper, a material, such as a vinyl film, a polyester film, a paper or a cloth covered with release coating may be used.

In accordance with the present invention, the heat-dissipation sheet assembly has the following effects:
- Even if an external force is applied to the heat-dissipation sheet assembly attached to the heat-generating unit, the heat-dissipation sheet layer and the heat-dissipation sheet assembly are prevented from being damaged.
- Even if heat is repetitively generated from the heat-generating unit, separation between the layers of the heat-dissipation sheet assembly is prevented.
- Since the structure of the heat-dissipation sheet assembly is simple, it is easily manufactured.
- Since there are no layers to hinder the effects of dissipating and dispersing the heat, the effects of dissipating and dispersing the heat is more improved.

The invention has been described using preferred exemplary embodiments. However, it is to be understood that the scope of the invention is not limited to the disclosed embodiments. On the contrary, the scope of the invention is intended to include various modifications and alternative arrangements within the capabilities of persons skilled in the art using presently known or future technologies and equivalents. The scope of the claims, therefore, should be accorded the broadest interpretation so as to encompass all such modifications and similar arrangements.

## Claims

1. A heat-dissipation sheet assembly comprising:
a heat-dissipation sheet layer having good heat conductivity; and
a protection layer(s) electrodeposited on one or both sides of the heat-dissipation sheet layer by immersing the heat-dissipation sheet layer into an aqueous solution for electrodeposition with an added material for electrodeposition and permitting electric current to flow in the aqueous solution ,
and the heat-dissipation sheet assembly may be attached to a heat-generating unit by applying an adhesion layer to an underside of the heat-dissipation sheet assembly.

2. The heat-dissipation sheet assembly according to claim 1, wherein the heat-dissipation sheet layer is preprocessed by immersing into an aqueous solution containing a copper component before immersing into the aqueous solution for electrodeposition, for better electrodeposition.

3. The heat-dissipation sheet assembly according to claim 1, wherein the heat-dissipation sheet layer is a thin film made of a natural graphite, artificial graphite, copper, silver, aluminum or gold sheet.

4. The heat-dissipation sheet assembly according to claim 1, wherein the material for electrodeposition is gold, silver, copper, aluminium or nickel.

5. The heat-dissipation sheet assembly according to claim 1, wherein the aqueous solution for electrodeposition is a solution with added sodium cyanide or organic acid silver, or a solution with added nickel sulfamate, nickel chloride and boric acid.

6. The heat-dissipation sheet assembly according to claim 1, wherein the thickness of the heat-dissipation sheet layer is 10~40 µm and the thickness of the protection layer is 0.1~3 µm.

7. The heat-dissipation sheet assembly according to claim 1 further comprising:
an adhesion layer to attach the heat-dissipation sheet assembly to the heat-generating unit; and
a release paper on an underside of the adhesion layer, the release paper being easily detached from the adhesion layer.
